(19) 

**Europäisches Patentamt**
**European Patent Office**
**Office européen des brevets**

(11) **EP 4 615 211 A1**

(12) **EUROPEAN PATENT APPLICATION**
published in accordance with Art. 153(4) EPC

(43) Date of publication:
**10.09.2025 Bulletin 2025/37**

(21) Application number: **23885717.1**

(22) Date of filing: **30.10.2023**

(51) International Patent Classification (IPC):
*H10N 30/853* (2023.01)   *C04B 35/495* (2006.01)
*H10N 30/06* (2023.01)   *H10N 30/87* (2023.01)

(52) Cooperative Patent Classification (CPC):
**C04B 35/495; H10N 30/06; H10N 30/853;**
**H10N 30/87**

(86) International application number:
**PCT/JP2023/039101**

(87) International publication number:
**WO 2024/095963 (10.05.2024 Gazette 2024/19)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **31.10.2022 JP 2022174998**

(71) Applicant: **Kyocera Corporation**
**Kyoto-shi, Kyoto 612-8501 (JP)**

(72) Inventors:
• **MAIBARA, Shunsuke**
**Kyoto-shi, Kyoto 612-8501 (JP)**
• **YONEYAMA, Kenta**
**Kyoto-shi, Kyoto 612-8501 (JP)**
• **TERUMINE, Tatsuaki**
**Kyoto-shi, Kyoto 612-8501 (JP)**
• **KAWAMOTO, Tomohiro**
**Kyoto-shi, Kyoto 612-8501 (JP)**

(74) Representative: **Viering, Jentschura & Partner**
**mbB**
**Patent- und Rechtsanwälte**
**Am Brauhaus 8**
**01099 Dresden (DE)**

(54) **PIEZOELECTRIC CERAMIC AND PIEZOELECTRIC ELEMENT**

(57) A piezoelectric ceramic of the present disclosure contains, in potassium sodium niobate, at least one selected from the group consisting of strontium zirconate, barium zirconate, strontium titanate, and barium titanate.

A piezoelectric element of the present disclosure includes a pair of electrodes on one surface of the piezoelectric ceramic and on the other surface located opposite to the one surface.

EP 4 615 211 A1

**Description**

TECHNICAL FIELD

The present disclosure relates to a piezoelectric ceramic and a piezoelectric element.

BACKGROUND OF INVENTION

For components requiring piezoelectric characteristics, PZT (lead zirconate titanate)-based materials and PT (lead titanate)-based materials have been used. However, in recent years, there has been an increasing trend to restrict the use of lead from the viewpoint of global environmental protection, and high expectations have been placed on lead-free piezoelectric materials, which have been actively researched and developed. Patent Document 1 discloses an alkali niobate-based piezoelectric material in which an alkali metal is disposed at an A-site and niobium is disposed at a B-site of a perovskite structure (general formula $ABO_3$).

CITATION LIST

PATENT LITERATURE

Patent Document 1: JP 2006-028001 A

SUMMARY

A piezoelectric ceramic of the present disclosure contains, in potassium sodium niobate (KNN), at least one selected from the group consisting of strontium zirconate ($SrZrO_3$), barium zirconate ($BaZrO_3$), strontium titanate ($SrTiO_3$), and barium titanate ($BaTiO_3$).

DESCRIPTION OF EMBODIMENTS

For components requiring piezoelectric characteristics, PZT (lead zirconate titanate)-based materials and PT (lead titanate)-based materials have been used for components requiring piezoelectric characteristics. However, in recent years, there has been an increasing trend to restrict the use of lead from the viewpoint of global environmental protection, and high expectations have been placed on lead-free piezoelectric materials, which have been actively researched and developed. Patent Document 1 discloses an alkali niobate-based piezoelectric material in which an alkali metal is disposed at an A-site and niobium is disposed at a B-site of a perovskite structure (general formula $ABO_3$).

The lead-free piezoelectric material is inferior in piezoelectric characteristics to the PZT-based material and the PT-based material. However, in recent years, from the viewpoint of global environmental protection, there has been a movement toward practical use even if the piezoelectric characteristics equivalent to those of the PZT-based materials and the PT-based materials cannot be obtained.

Despite such trend, for example, in a piezoelectric element, excellent element characteristics are naturally required, and therefore improvement of the piezoelectric characteristics is required in a material containing no lead.

Thus, it is expected to achieve a technique capable of overcoming the above-described issues and providing a piezoelectric ceramic and a piezoelectric element excellent in piezoelectric characteristics in a lead-free material.

The piezoelectric ceramic of the present disclosure contains, in potassium sodium niobate (KNN), at least one selected from the group consisting of strontium zirconate ($SrZrO_3$), barium zirconate ($BaZrO_3$), strontium titanate ($SrTiO_3$), and barium titanate ($BaTiO_3$). Potassium sodium niobate is a main component of the piezoelectric ceramic, and here, a main component means a component that accounts for 95 mass% or more in total of values obtained by converting sodium into $Na_2O$, potassium into $K_2O$, and niobium into $Nb_2O_5$, of 100 mass% of all components included in the piezoelectric ceramic.

Since the piezoelectric ceramic of the present disclosure contains, in potassium sodium niobate, at least one selected from the group consisting of strontium zirconate, barium zirconate, strontium titanate, and barium titanate, the piezoelectric ceramic has more excellent piezoelectric characteristics than a piezoelectric ceramic containing no strontium zirconate, barium zirconate, strontium titanate, or barium titanate. Specifically, the piezoelectric constant d31 has a large value.

Next, an example of a preparation composition formula of potassium sodium niobate in the piezoelectric ceramic of the present disclosure will be described.

$$(1-x)\{(K_{1-a}Na_a)_{1-b}Li_b\}_c (Nb_{1-d-e}Ta_dSb_e)O_3 + xBi_\alpha(A1_{1-\beta}A2_\beta)O_3 \qquad \cdots \text{Formula 1}$$

Note that x, a, b, c, d, e, $\alpha$, and $\beta$ are respectively in ranges of:

$$0 \leq x \leq 0.005;$$

$$0.30 \leq a \leq 0.60;$$

$$0.01 \leq b \leq 0.06;$$

$$0.99 \leq c \leq 1.01;$$

$$0.08 \leq d \leq 0.13;$$

$$0.05 \leq e \leq 0.09;$$

$$2/3 \leq \alpha \leq 1;$$

$$1/3 \leq \beta \leq 2/3,$$

and A1 is at least one selected from the element group consisting of Mg, Cu, and Zn, and A2 is at least one selected from the element group consisting of Nb, Ta, Sb, Ti, Zr, Hf, Ge, Sn, and Ce. $\{(K_{1-a}Na_a)_{1-b}Li_b\}_c (Nb_{1-d-e}Ta_dSb_e)O_3$ has a perovskite structure. In the following description, since $\{(K_{1-a}Na_a)_{1-b}Li_b\}_c (Nb_{1-d-e}Ta_dSb_e)O_3$ is a main component of the piezoelectric ceramic, it may be simply referred to as the main component hereinafter.

A composition range satisfying x, a, b, c, d, and e as denoted by Formula 1 is a composition range including a so-called MPB (Morphotoropic Phase Boundary) region and a PPT (Polymorphic Phase Transition) including a boundary at which a crystal structure changes.

Next, Formula 1 will be divided into multiple components and described. Potassium sodium niobate having a composition as denoted by Formula 2 described below is a main component of the piezoelectric ceramic and has a perovskite structure.

$$\{(K_{1-a}Na_a)_{1-b}Li_b\}_c (Nb_{1-d-e}Ta_dSb_e)O_3 \qquad \cdots \text{ Formula 2}$$

The piezoelectric constant can be increased by setting a in a range of $0.30 \leq a \leq 0.60$ and substituting a part of K with Na in Formula 2.

By setting b within the range of $0.01 \leq b \leq 0.06$, the piezoelectric constant can be increased.

The reason why d is set to the range of $0.08 \leq d \leq 0.13$ is that the piezoelectric constant can be increased by substituting a part of Nb with Ta.

The reason why e is set to the range of $0.05 \leq e \leq 0.09$ is that sinterability can be improved by substituting a part of Nb with Sb, as necessary.

Next, by introducing a Bi composite oxide as denoted by Formula 3 described below into such potassium sodium niobate, the piezoelectric characteristics are further improved. Specifically, the piezoelectric constant d31 has a large value.

$$xBi_\alpha(A1_{1-\beta}A2_\beta)O_3 \qquad \cdots \text{ Formula 3}$$

The Bi composite oxide as denoted by Formula 3 has a composite perovskite structure, and Bi has a 6s2 lone electron pair, so that the crystal structure has large distortion. By introducing a predetermined amount of the Bi composite oxide into potassium sodium niobate as denoted by Formula 2, distortion is introduced into the crystal structure of potassium sodium niobate, polarization is increased, and the piezoelectric characteristics are excellent.

Since a compound containing Bi generates a liquid phase at a relatively low temperature, the introduction of the Bi composite oxide also provides an effect of lowering a firing temperature of the piezoelectric ceramic.

Here, $\alpha$ is in a range of $2/3 \leq \alpha \leq 1$. By setting $\alpha$ within such a range, the Bi composite oxide can be incorporated into potassium sodium niobate without excess or deficiency.

The first metal element A1 in Formula 3 includes any one selected from Mg, Cu, and Zn, and the second metal element A2 includes any one selected from Nb, Ta, Sb, Ti, Zr, Hf, Ge, Sn, and Ce. When the first metal element is Zn and the second metal element A2 is Sn, the piezoelectric constant is particularly excellent.

$\beta$ is in a range of $1/3 \leq \beta \leq 2/3$. By setting $\beta$ within such a range, a ratio between A1 and A2 can be set within a stoichiometric ratio range.

When A2 is an element that turns into a pentavalent ion, that is, Nb, Ta, and Sb, setting $\alpha + \beta$ to 4/3 enables A1 and A2 to fall within the stoichiometric ratio range, which is preferable. In addition, when A2 is an element that becomes a tetravalent ion, that is, Ti, Zr, Hf, Ge, Sn, and Ce, setting $\beta$ to 1/2 enables A1 and A2 to fall within the stoichiometric ratio range, which is preferable.

As described above, by introducing the complex perovskite structure of the Bi composite oxide as denoted by Formula 3, in which the distortion is large, into the composite perovskite structure of potassium sodium niobate as denoted by Formula 2, the piezoelectric constant can be increased, and temperature dependence of the piezoelectric characteristics can be reduced.

A ratio of the Bi composite oxide to potassium sodium niobate is denoted by x in Formula 1, and x is $0 \leq x \leq 0.005$. By setting x within such a range, moderate distortion is introduced into the perovskite structure of potassium sodium niobate, and the piezoelectric constant can be increased.

In addition, the piezoelectric ceramic of the present disclosure contains Mn in an amount of from 0 to 1.04 parts by mass in terms of $MnO_2$ with respect to 100 parts by mass of the component as denoted by Formula 1 described above. Furthermore, Sr is contained in an amount of from 0.351 to 1.287 parts by mass in terms of $SrZrO_3$ with respect to 100 parts by mass of the component as denoted by Formula 1 described above.

The purpose of containing Mn is to improve insulating properties of the piezoelectric ceramic. When the piezoelectric ceramic contains Mn, the insulating properties are improved, and a current during driving hardly flows to a portion other than a predetermined portion. Thus, when Mn is contained, the piezoelectric ceramic has excellent reliability.

The piezoelectric constant can be increased by containing strontium zirconate ($SrZrO_3$) in the piezoelectric ceramic.

Instead of strontium zirconate ($SrZrO_3$), barium zirconate ($BaZrO_3$), strontium titanate ($SrTiO_3$), and barium titanate ($BaTiO_3$) may be contained. Similarly, the piezoelectric constant can be increased.

The piezoelectric constant can be increased by containing silicon dioxide ($SiO_2$) in the piezoelectric ceramic. Specifically, by containing silicon dioxide ($SiO_2$), the silicon dioxide is present at a grain boundary of the crystal structure, and the electrode is less likely to be diffused inside when the piezoelectric element is formed.

The piezoelectric ceramic including Formula 1 described above and a preparation composition containing Mn and Sr in the contents described above exhibits excellent piezoelectric characteristics in which the piezoelectric constant d31 is 100 or more and a Curie temperature is 200°C or higher.

In the above-described range of x, when x = 0, Bi, A1, and A2 are not included, and only the main component is included. Even in such a case, when a desired amount of Sr is contained, excellent piezoelectric characteristics are exhibited.

In the piezoelectric ceramic of the present disclosure, a total of Formula 1 described above and a component containing Mn and Sr in the contents described above may account for 99 mass% or more. A total amount of the other impurity elements in terms of oxides may be less than 0.5 mass%, less than 0.2 mass%, or less than 0.1 mass%. Examples of the impurity element include impurity elements derived from a manufacturing process of the piezoelectric ceramic, for example, Fe, Ni, Co, Cr, and Al, and there is no issue in characteristics as long as a total amount in terms of oxides is a trace amount of less than 0.5 mass%. The composition of the piezoelectric ceramic and the content of impurity elements can be confirmed by elemental analysis such as fluorescent X-ray analysis and ICP emission spectrometry.

An example of a method for manufacturing the piezoelectric ceramic of the present disclosure will be described. In order to produce the piezoelectric ceramic of the present disclosure, carbonates such as $Na_2CO_3$, $K_2CO_3$, $Li_2CO_3$, and $MgCO_3$, and oxides such as CuO, $Cu_2O$, CaO, BaO, MgO, $SiO_2$, $Fe_2O_3$, ZnO, $Nb_2O_5$, $Ta_2O_5$, $Sb_2O_3$, $TiO_2$, $ZrO_2$, $HfO_2$, $GeO_2$, $SnO_2$, $Ce_2O_3$, $Bi_2O_3$, $MnO_2$, and $SrZrO_3$ may be used as raw materials. The raw materials are not limited to these, and for example, a metal salt such as a nitrate, which generates an oxide by firing, may be used.

In Formula 1 described above, at least one selected from the element group consisting of Mg, Cu, and Zn is selected for A1, at least one selected from the element group consisting of Nb, Ta, Sb, Ti, Zr, Hf, Ge, Sn, and Ce is selected for A2, and the above-described raw materials are used to provide a predetermined range, and weighed so that Mn is from 0 to 1.04 parts by mass in terms of $MnO_2$ and Sr is from 0.351 to 1.287 parts by mass in terms of $SrZrO_3$ with respect to 100 parts by mass of the component of Formula 1. The weighed raw materials are mixed to form a mixture, and the mixture is pulverized so that an average particle diameter (D50) in a particle size distribution is in a range of from 0.1 to 30 μm. This mixture is calcined and synthesized at from 600°C to 1000°C to obtain a synthetic product. The obtained synthetic product is pulverized, and the average particle diameter (D50) in the particle size distribution is adjusted to a range of 10 μm. Thereafter, a predetermined binder is added and wet-mixed to obtain a granulated powder.

The obtained granulated powder is molded into a predetermined shape by a well-known molding method such as press molding or tape molding, and fired in an oxidizing atmosphere such as the air at a temperature range of from 850°C to 1150°C for from 2 to 10 hours to obtain a piezoelectric ceramic.

A piezoelectric element can be obtained by disposing a pair of electrodes on one surface of such a piezoelectric ceramic and the other surface located opposite to the one surface. In this case, a metal such as an Ag-Pd alloy or Ni is considered as a material of the electrode.

A laminate can be obtained by stacking the piezoelectric elements. Specifically, first, a binder and a plasticizer are added and mixed with a metal powder such as an Ag-Pd alloy or Ni serving as an internal electrode to prepare a conductive paste. This conductive paste is printed on the piezoelectric element using a screen printing method. Next, a plurality of piezoelectric elements on which the conductive paste is printed are stacked, and a plurality of ceramic green sheets on which the conductive paste is not printed are stacked at both end portions in a stacking direction to obtain a laminated molded body. The laminated molded body is debindered at a predetermined temperature and then fired to obtain a laminate.

Further effects and variations can be readily derived by those skilled in the art. Thus, a wide variety of aspects of the present disclosure are not limited to the specific details and representative embodiments represented and described above. Accordingly, various modifications are possible without departing from the spirit or scope of the general inventive concept as defined by the appended claims and equivalents thereof.

EXAMPLES

Piezoelectric ceramics having various compositions listed in Tables 1, 2, 3, and 4 were prepared, and the piezoelectric constant and the Curie temperature were measured. The results are listed in Tables 3 and 4.

[Table 1]

(Table 1)

| Sample No. | Preparation composition | | | | | | | |
|---|---|---|---|---|---|---|---|---|
| | x | a | b | c | d | e | MnO$_2$ (parts by mass) | SrZrO$_3$ (parts by mass) |
| 1 | 0.0025 | 0.49 | 0.05 | 1 | 0.1 | 0.06 | 0.52 | 0 |
| 2 | 0.0025 | 0.49 | 0.05 | 1 | 0.1 | 0.06 | 0.52 | 0.234 |
| 3 | 0.0025 | 0.49 | 0.05 | 1 | 0.1 | 0.06 | 0.52 | 0.351 |
| 4 | 0.0025 | 0.49 | 0.05 | 1 | 0.1 | 0.06 | 0.52 | 0.468 |
| 5 | 0.0025 | 0.49 | 0.05 | 1 | 0.1 | 0.06 | 0.52 | 0.585 |
| 6 | 0.0025 | 0.49 | 0.05 | 1 | 0.1 | 0.06 | 0.52 | 0.702 |
| 7 | 0.0025 | 0.49 | 0.05 | 1 | 0.1 | 0.06 | 0.52 | 0.819 |
| 8 | 0.0025 | 0.49 | 0.05 | 1 | 0.1 | 0.06 | 0.52 | 0.936 |
| 9 | 0.0025 | 0.49 | 0.05 | 1 | 0.1 | 0.06 | 0.52 | 1.17 |
| 10 | 0.0025 | 0.49 | 0.05 | 1 | 0.1 | 0.06 | 0.52 | 1.287 |
| 11 | 0 | 0.49 | 0.05 | 1 | 0.1 | 0.06 | 0.52 | 0.702 |
| 12 | 0.0005 | 0.49 | 0.05 | 1 | 0.1 | 0.06 | 0.52 | 0.702 |
| 13 | 0.001 | 0.49 | 0.05 | 1 | 0.1 | 0.06 | 0.52 | 0.702 |
| 14 | 0.0015 | 0.49 | 0.05 | 1 | 0.1 | 0.06 | 0.52 | 0.702 |
| 15 | 0.002 | 0.49 | 0.05 | 1 | 0.1 | 0.06 | 0.52 | 0.702 |
| 16 | 0.0025 | 0.49 | 0.05 | 1 | 0.1 | 0.06 | 0.52 | 0.702 |
| 17 | 0.003 | 0.49 | 0.05 | 1 | 0.1 | 0.06 | 0.52 | 0.702 |
| 18 | 0.0035 | 0.49 | 0.05 | 1 | 0.1 | 0.06 | 0.52 | 0.702 |
| 19 | 0.004 | 0.49 | 0.05 | 1 | 0.1 | 0.06 | 0.52 | 0.702 |

(continued)

| Sample No. | Preparation composition | | | | | | | |
|---|---|---|---|---|---|---|---|---|
| | x | a | b | c | d | e | $MnO_2$ (parts by mass) | $SrZrO_3$ (parts by mass) |
| 20 | 0.0045 | 0.49 | 0.05 | 1 | 0.1 | 0.06 | 0.52 | 0.702 |
| 21 | 0.005 | 0.49 | 0.05 | 1 | 0.1 | 0.06 | 0.52 | 0.702 |
| 22 | 0.006 | 0.49 | 0.05 | 1 | 0.1 | 0.06 | 0.52 | 0.702 |
| 23 | 0.0025 | 0.2 | 0.05 | 1 | 0.1 | 0.06 | 0.52 | 0.702 |
| 24 | 0.0025 | 0.3 | 0.05 | 1 | 0.1 | 0.06 | 0.52 | 0.702 |
| 25 | 0.0025 | 0.4 | 0.05 | 1 | 0.1 | 0.06 | 0.52 | 0.702 |
| 26 | 0.0025 | 0.45 | 0.05 | 1 | 0.1 | 0.06 | 0.52 | 0.702 |
| 27 | 0.0025 | 0.49 | 0.05 | 1 | 0.1 | 0.06 | 0.52 | 0.702 |
| 28 | 0.0025 | 0.55 | 0.05 | 1 | 0.1 | 0.06 | 0.52 | 0.702 |
| 29 | 0.0025 | 0.6 | 0.05 | 1 | 0.1 | 0.06 | 0.52 | 0.702 |
| 30 | 0.0025 | 0.7 | 0.05 | 1 | 0.1 | 0.06 | 0.52 | 0.702 |

[Table 2]

(Table 2)

| Sample No. | Preparation composition | | | | | | | |
|---|---|---|---|---|---|---|---|---|
| | x | a | b | c | d | e | $MnO_2$ (parts by mass) | $SrZrO_3$ (parts by mass) |
| 31 | 0.0025 | 0.535 | 0.005 | 1 | 0.1 | 0.06 | 0.52 | 0.702 |
| 32 | 0.0025 | 0.53 | 0.01 | 1 | 0.1 | 0.06 | 0.52 | 0.702 |
| 33 | 0.0025 | 0.5 | 0.04 | 1 | 0.1 | 0.06 | 0.52 | 0.702 |
| 34 | 0.0025 | 0.49 | 0.05 | 1 | 0.1 | 0.06 | 0.52 | 0.702 |
| 35 | 0.0025 | 0.48 | 0.06 | 1 | 0.1 | 0.06 | 0.52 | 0.702 |
| 36 | 0.0025 | 0.48 | 0.07 | 1 | 0.1 | 0.06 | 0.52 | 0.702 |
| 37 | 0.0025 | 0.49 | 0.05 | 0.98 | 0.1 | 0.06 | 0.52 | 0.702 |
| 38 | 0.0025 | 0.49 | 0.05 | 0.99 | 0.1 | 0.06 | 0.52 | 0.702 |
| 39 | 0.0025 | 0.49 | 0.05 | 1.01 | 0.1 | 0.06 | 0.52 | 0.702 |
| 40 | 0.0025 | 0.49 | 0.05 | 1.02 | 0.1 | 0.06 | 0.52 | 0.702 |
| 41 | 0.0025 | 0.49 | 0.05 | 1 | 0.08 | 0.06 | 0.52 | 0.702 |
| 42 | 0.0025 | 0.49 | 0.05 | 1 | 0.09 | 0.06 | 0.52 | 0.702 |
| 43 | 0.0025 | 0.49 | 0.05 | 1 | 0.11 | 0.05 | 0.52 | 0.702 |
| 44 | 0.0025 | 0.49 | 0.05 | 1 | 0.11 | 0.055 | 0.52 | 0.702 |
| 45 | 0.0025 | 0.49 | 0.05 | 1 | 0.12 | 0.05 | 0.52 | 0.702 |
| 46 | 0.0025 | 0.49 | 0.05 | 1 | 0.12 | 0.06 | 0.52 | 0.702 |
| 47 | 0.0025 | 0.49 | 0.05 | 1 | 0.13 | 0.05 | 0.52 | 0.702 |
| 48 | 0.0025 | 0.49 | 0.05 | 1 | 0.14 | 0.05 | 0.52 | 0.702 |
| 49 | 0.0025 | 0.49 | 0.05 | 1 | 0.1 | 0.04 | 0.52 | 0.702 |
| 50 | 0.0025 | 0.49 | 0.05 | 1 | 0.1 | 0.05 | 0.52 | 0.702 |
| 51 | 0.0025 | 0.49 | 0.05 | 1 | 0.1 | 0.055 | 0.52 | 0.702 |

(continued)

| Sample No. | Preparation composition | | | | | | | |
|---|---|---|---|---|---|---|---|---|
| | x | a | b | c | d | e | $MnO_2$ (parts by mass) | $SrZrO_3$ (parts by mass) |
| 52 | 0.0025 | 0.49 | 0.05 | 1 | 0.1 | 0.065 | 0.52 | 0.702 |
| 53 | 0.0025 | 0.49 | 0.05 | 1 | 0.1 | 0.09 | 0.52 | 0.702 |
| 54 | 0.0025 | 0.49 | 0.05 | 1 | 0.1 | 0.1 | 0.52 | 0.702 |
| 55 | 0.0025 | 0.49 | 0.05 | 1 | 0.1 | 0.06 | 0 | 0.702 |
| 56 | 0.0025 | 0.49 | 0.05 | 1 | 0.1 | 0.06 | 0.52 | 0.702 |
| 57 | 0.0025 | 0.49 | 0.05 | 1 | 0.1 | 0.06 | 1.04 | 0.702 |
| 58 | 0.0025 | 0.49 | 0.05 | 1 | 0.1 | 0.06 | 1.56 | 0.702 |

[Table 3]

(Table 3)

| Sample No. | Element type | | Preparation composition | | Piezoelectric constant d31 | Curie temperature |
|---|---|---|---|---|---|---|
| | A1 | A2 | $\alpha$ | $\beta$ | pC/N | Tc |
| 1 | Zn | Sn | 1 | 0.5 | 92.4 | 265 |
| 2 | Zn | Sn | 1 | 0.5 | 99.9 | 264 |
| 3 | Zn | Sn | 1 | 0.5 | 105.0 | 262 |
| 4 | Zn | Sn | 1 | 0.5 | 115.7 | 262 |
| 5 | Zn | Sn | 1 | 0.5 | 123.9 | 255 |
| 6 | Zn | Sn | 1 | 0.5 | 140.8 | 252 |
| 7 | Zn | Sn | 1 | 0.5 | 143.9 | 250 |
| 8 | Zn | Sn | 1 | 0.5 | 133.2 | 246 |
| 9 | Zn | Sn | 1 | 0.5 | 132.5 | 240 |
| 10 | Zn | Sn | 1 | 0.5 | 131.0 | 235 |
| 11 | - | - | - | - | 106.8 | 266 |
| 12 | Zn | Sn | 1 | 0.5 | 110.0 | 260 |
| 13 | Zn | Sn | 1 | 0.5 | 117.8 | 255 |
| 14 | Zn | Sn | 1 | 0.5 | 118.0 | 252 |
| 15 | Zn | Sn | 1 | 0.5 | 130.2 | 250 |
| 16 | Zn | Sn | 1 | 0.5 | 140.5 | 250 |
| 17 | Zn | Sn | 1 | 0.5 | 145.3 | 252 |
| 18 | Zn | Sn | 1 | 0.5 | 141.3 | 245 |
| 19 | Zn | Sn | 1 | 0.5 | 118.1 | 237 |
| 20 | Zn | Sn | 1 | 0.5 | 125.9 | 240 |
| 21 | Zn | Sn | 1 | 0.5 | 104.4 | 240 |
| 22 | Zn | Sn | 1 | 0.5 | 88.0 | 238 |
| 23 | Zn | Sn | 1 | 0.5 | 95.0 | 255 |
| 24 | Zn | Sn | 1 | 0.5 | 105.3 | 248 |

(continued)

| Sample No. | Element type | | Preparation composition | | Piezoelectric constant d31 | Curie temperature |
|---|---|---|---|---|---|---|
| | A1 | A2 | α | β | pC/N | Tc |
| 25 | Zn | Sn | 1 | 0.5 | 114.6 | 255 |
| 26 | Zn | Sn | 1 | 0.5 | 118.1 | 260 |
| 27 | Zn | Sn | 1 | 0.5 | 141.2 | 252 |
| 28 | Zn | Sn | 1 | 0.5 | 140.1 | 252 |
| 29 | Zn | Sn | 1 | 0.5 | 110.3 | 260 |
| 30 | Zn | Sn | 1 | 0.5 | 55.3 | 240 |

[Table 4]

(Table 4)

| Sample No. | Element type | | Preparation composition | | Piezoelectric constant d31 | Curie temperature |
|---|---|---|---|---|---|---|
| | A1 | A2 | α | β | pC/N | Tc |
| 31 | Zn | Sn | 1 | 0.5 | 93.0 | 198 |
| 32 | Zn | Sn | 1 | 0.5 | 101.0 | 210 |
| 33 | Zn | Sn | 1 | 0.5 | 118.5 | 240 |
| 34 | Zn | Sn | 1 | 0.5 | 141.2 | 250 |
| 35 | Zn | Sn | 1 | 0.5 | 122.5 | 250 |
| 36 | Zn | Sn | 1 | 0.5 | 92.0 | 280 |
| 37 | Zn | Sn | 1 | 0.5 | 97.0 | 249 |
| 38 | Zn | Sn | 1 | 0.5 | 106.3 | 250 |
| 39 | Zn | Sn | 1 | 0.5 | 106.0 | 252 |
| 40 | Zn | Sn | 1 | 0.5 | 98.0 | 252 |
| 41 | Zn | Sn | 1 | 0.5 | 130.0 | 249 |
| 42 | Zn | Sn | 1 | 0.5 | 138.5 | 248 |
| 43 | Zn | Sn | 1 | 0.5 | 123.4 | 260 |
| 44 | Zn | Sn | 1 | 0.5 | 135.7 | 257 |
| 45 | Zn | Sn | 1 | 0.5 | 124.3 | 256 |
| 46 | Zn | Sn | 1 | 0.5 | 132.1 | 240 |
| 47 | Zn | Sn | 1 | 0.5 | 115.0 | 240 |
| 48 | Zn | Sn | 1 | 0.5 | 99.0 | 228 |
| 49 | Zn | Sn | 1 | 0.5 | 98.0 | 290 |
| 50 | Zn | Sn | 1 | 0.5 | 125.7 | 270 |
| 51 | Zn | Sn | 1 | 0.5 | 128.3 | 260 |
| 52 | Zn | Sn | 1 | 0.5 | 143.8 | 244 |
| 53 | Zn | Sn | 1 | 0.5 | 124.0 | 201 |
| 54 | Zn | Sn | 1 | 0.5 | 107.7 | 180 |

(continued)

| Sample No. | Element type | | Preparation composition | | Piezoelectric constant d31 | Curie temperature |
|---|---|---|---|---|---|---|
| | A1 | A2 | $\alpha$ | $\beta$ | pC/N | Tc |
| 55 | Zn | Sn | 1 | 0.5 | 152.3 | 255 |
| 56 | Zn | Sn | 1 | 0.5 | 141.5 | 252 |
| 57 | Zn | Sn | 1 | 0.5 | 100.5 | 250 |
| 58 | Zn | Sn | 1 | 0.5 | 85.3 | 265 |

It was found that the piezoelectric ceramic including Formula 1 and a preparation composition containing Mn and Sr in desired contents had a piezoelectric constant d31 of 100 or more and a Curie temperature of 200°C or higher, and had excellent piezoelectric characteristics.

Note that the present technique can also have the following configurations.

(1) A piezoelectric ceramic including, in potassium sodium niobate, at least one selected from the group consisting of strontium zirconate, barium zirconate, strontium titanate, and barium titanate.

(2) The piezoelectric ceramic according to (1) described above, including a Bi composite oxide having a composite perovskite structure.

(3) The piezoelectric ceramic according to (2) described above, wherein when the Bi composite oxide is denoted as $Bi_\alpha(A1_{1-\beta}A2_\beta)O_3$, A1 contains any one selected from Mg, Cu, and Zn, and A2 contains any one selected from Nb, Ta, Sb, Ti, Zr, Hf, Ge, Sn, and Ce.

(4) The piezoelectric ceramic according to (3) described above, wherein the A1 is Zn, and the A2 is Sn.

(5) The piezoelectric ceramic according to any one of (1) to (4) described above, including silicon dioxide.

(6) A piezoelectric element including a pair of electrodes on one surface of the piezoelectric ceramic according to any one of (1) to (5) and on the other surface located opposite to the one surface.

## Claims

1.    A piezoelectric ceramic comprising, in potassium sodium niobate, at least one selected from the group consisting of strontium zirconate, barium zirconate, strontium titanate, and barium titanate.

2.    The piezoelectric ceramic according to claim 1, comprising a Bi composite oxide having a composite perovskite structure.

3.    The piezoelectric ceramic according to claim 2, wherein, when the Bi composite oxide is denoted as $Bi_\alpha(A1_{1-\beta}A2_\beta)O_3$, A1 comprises any one selected from Mg, Cu, and Zn, and A2 comprises any one selected from Nb, Ta, Sb, Ti, Zr, Hf, Ge, Sn, and Ce.

4.    The piezoelectric ceramic according to claim 3, wherein the A1 is Zn, and the A2 is Sn.

5.    The piezoelectric ceramic according to any one of claims 1 to 4, comprising silicon dioxide.

6.    A piezoelectric element comprising a pair of electrodes on one surface of the piezoelectric ceramic according to any one of claims 1 to 5 and on the other surface located opposite to the one surface.

## INTERNATIONAL SEARCH REPORT

| International application No. |
| --- |
| **PCT/JP2023/039101** |

**A. CLASSIFICATION OF SUBJECT MATTER**

*H10N 30/853*(2023.01)i; *C04B 35/495*(2006.01)i; *H10N 30/06*(2023.01)i; *H10N 30/87*(2023.01)i
FI:   H10N30/853; C04B35/495; H10N30/06; H10N30/87

According to International Patent Classification (IPC) or to both national classification and IPC

**B. FIELDS SEARCHED**

Minimum documentation searched (classification system followed by classification symbols)

    H10N30/853; C04B35/495; H10N30/06; H10N30/87

Documentation searched other than minimum documentation to the extent that such documents are included in the fields searched

    Published examined utility model applications of Japan 1922-1996
    Published unexamined utility model applications of Japan 1971-2023
    Registered utility model specifications of Japan 1996-2023
    Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2012-508681 A (EPCOS AG) 12 April 2012 (2012-04-12) paragraphs [0022]-[0050], fig. 1-11 | 1, 2, 6 |
| A | | 3, 4 |
| X | JP 2005-179143 A (TDK CORP.) 07 July 2005 (2005-07-07) paragraphs [0020]-[0101], fig. 1-3 | 1, 6 |
| Y | | 5 |
| A | | 3, 4 |
| X | JP 2005-179144 A (TDK CORP.) 07 July 2005 (2005-07-07) paragraphs [0020]-[0099], fig. 1-3 | 1, 6 |
| Y | | 5 |
| A | | 3, 4 |
| Y | JP 2002-068835 A (TOYOTA CENTRAL R&D LABS., INC.) 08 March 2002 (2002-03-08) paragraphs [0013]-[0061], fig. 1, 2 | 5 |
| A | | 3, 4 |

☑ Further documents are listed in the continuation of Box C.  ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **12 December 2023** | **26 December 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
|---|
| **PCT/JP2023/039101** |

**C. DOCUMENTS CONSIDERED TO BE RELEVANT**

| Category* | Citation of document, with indication, where appropriate, of the relevant passages | Relevant to claim No. |
|---|---|---|
| A | JP 2020-152630 A (KOREA ADVANCED INSTITUTE OF SCIENCE AND TECHNOLOGY) 24 September 2020 (2020-09-24) | 3, 4 |
| A | WO 2020/184243 A1 (KYOCERA CORP.) 17 September 2020 (2020-09-17) | 3, 4 |

Form PCT/ISA/210 (second sheet) (January 2015)

**INTERNATIONAL SEARCH REPORT**
**Information on patent family members**

International application No.

**PCT/JP2023/039101**

| Patent document cited in search report | | | Publication date (day/month/year) | Patent family member(s) | | | Publication date (day/month/year) |
|---|---|---|---|---|---|---|---|
| JP | 2012-508681 | A | 12 April 2012 | US | 2012/0098386 | A1 | |
| | | | | paragraphs [0031]-[0067], fig. 1-11 | | | |
| | | | | WO | 2010/054994 | A1 | |
| | | | | EP | 2349949 | A1 | |
| | | | | DE | 102008057721 | A1 | |
| | | | | CN | 102216239 | A | |
| JP | 2005-179143 | A | 07 July 2005 | US | 2007/0152183 | A1 | |
| | | | | paragraphs [0023]-[0094], fig. 1-3 | | | |
| | | | | WO | 2005/061413 | A1 | |
| | | | | EP | 1702906 | A1 | |
| | | | | TW | 200529481 | A | |
| | | | | KR | 10-2006-0105788 | A | |
| | | | | CN | 1898182 | A | |
| JP | 2005-179144 | A | 07 July 2005 | (Family: none) | | | |
| JP | 2002-068835 | A | 08 March 2002 | (Family: none) | | | |
| JP | 2020-152630 | A | 24 September 2020 | US | 2020/0299197 | A1 | |
| | | | | KR | 10-2020-0110946 | A | |
| | | | | CN | 111718193 | A | |
| WO | 2020/184243 | A1 | 17 September 2020 | US | 2022/0149266 | A1 | |
| | | | | EP | 3923355 | A1 | |
| | | | | CN | 113557611 | A | |

Form PCT/ISA/210 (patent family annex) (January 2015)

**EP 4 615 211 A1**

**REFERENCES CITED IN THE DESCRIPTION**

**Patent documents cited in the description**

- JP 2006028001 A